# EUROPÄISCHE PATENTSCHRIFT

(11) **EP 0 940 820 B1**
(45) Veröffentlichungstag und Bekanntmachung des Hinweises auf die Patenterteilung: **18.01.2006**
(21) Anmeldenummer: 99103416.6
(22) Anmeldetag: 22.02.1999
(51) Int. Cl.: H01B 12/10

(54) **Verfahren zur Herstellung eines bandförmigen Multifilamentsupraleiters mit Bi-Cuprat-Leiterfilamenten sowie entsprechend hergestellter Supraleiter**
Manufactoring method for a ribbon-shaped multifilament-superconductor with Bi-Cuprat conductor-filaments and superconductor manufactored accordingly
Méthode de fabrication d'un supraconducteur à multifilaments en forme de ruban avec des filaments-conducteurs Bi-Cuprat et supraconducteur conformément fabriqué

(30) Priorität: 05.03.1998 DE 19809557
(43) Veröffentlichungstag der Anmeldung: 08.09.1999
(73) Patentinhaber: SIEMENS AKTIENGESELLSCHAFT, 80333 München (DE)
(72) Erfinder: Fischer, Bernard Dr., 91058 Erlangen (DE); Jenovelis, Alexander Dipl-.Ing. (FH), 91080 Spardorf (DE); Kautz, Stefan, 90607 Rückersdorf (DE)
(74) Vertreter: Patentanwälte Westphal, Mussgnug & Partner

(56) Entgegenhaltungen:
- EP-A- 0 503 525
- EP-A- 0 509 436
- DE-A- 4 444 937
- DE-A- 19 621 070

## Beschreibung

Die Erfindung bezieht sich auf ein Verfahren zur Herstellung eines bandformigen Multifilamentleiters mit mehreren supraleitenden Leiterfilamenten, welche jeweils ein metalloxidisches Supraleitermaterial enthalten, das zumindest teilweise ein Bi-Cuprat mit einer Hoch-T_{c}-Phase vom 2223-Typ aufweist und von mindestens einem normalleitenden Matrixmaterial umgeben ist, bei welchem Verfahren flachgearbeitete Leiterelemente ausgebildet werden, die ein von normalleitendem Material umgebendes Vormaterial des Supraleitermaterials oder das Supraleitermaterial in Form von mindestens einem Leiterkern mit einem Aspektverhältnis größer 1 besitzen, wobei das Aspektverhältnis der Quotient von Leiterkernbreite zu maximaler Leiterkerndicke ist, mehrere solcher Leiterelemente innerhalb einer zumindest weitgehend rechteckigen Umhüllung aus normalleitenden Material übereinander und/oder nebeneinander angeordnet werden und dieser Aufbau mittels einer querschnittsvermindernden Behandlung sowie einer Gluhbehandlung in das bandförmige Endprodukt des Multifilamentsupraleiters mit zu den Leiterfilamenten verformten Leiterkernen überfuhrt wird. Ein entsprechendes Verfahren geht aus der *EP 0 509 436 A2* hervor. Die Erfindung betrifft ferner einen entsprechend hergestellten bandförmigen Multifilamentsupraleiter.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und insbesondere eine Flussig-Stickstoff(LN₂)-Kuhltechnik erlauben. Unter solche Metalloxidverbindungen fallen insbesondere Cuprate auf Basis des Wismut-Stoffsystems Bi-Sr-Ca-Cu-O oder Bi(Pb)-Sr-Ca-Cu-O. Innerhalb dieser wismuthaltigen Stoffsysteme treten mindestens zwei supraleitende Hoch-T_{c}-Phasen auf, die sich durch die Anzahl ihrer Kupfer-Sauerstoff-Netzebenen (bzw. -Schichten) innerhalb der kristallinen Einheitszelle unterscheiden. Eine supraleitende Phase mit der ungefähren Zusammensetzung Bi₂Sr₂CaCu₂O_{8+y} hat eine Sprungtemperatur T_{c} von etwa 85 K (sogenannter 2-Schichter oder sogenannte 85 K- bzw. 2212-Phase), während die Sprungtemperatur T_{c} einer supraleitenden Phase mit der ungefähren Zusammensetzung Bi₂Sr₂Ca₂Cu₃O₁₀₋ₓ, bei etwa 110 K liegt (sogenannter 3-Schichter oder sogenannte 110 K- bzw. 2223-Phase). Innerhalb dieser Phase können einzee der metallischen Komponenten durch andere metallische Elemente ersetzt sein. Dies trifft insbesondere für eine teilweise Pb-Substitution der Bi-Komponente zu.

Mit diesen bekannten HTS-Materialien wird versucht, langgestreckte Supraleiter insbesondere in Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb₃Sn her bekannt ist. Entsprechend dieser Technik wird auch zur Herstellung von Leitern aus HTS-Material in einen rohrförmigen Hüllkörper bzw. in eine Matrix aus einem normalleitenden Material, insbesondere aus Ag oder einem Ag-haltigen Material, ein im allgemeinen pulverförmiges Vormaterial des HTS-Materials eingebracht. Dieses Vormaterial enthält dabei im allgemeinen noch nicht oder nur zu einem geringen Teil die gewünschte supraleitende Hoch-T_{c}-Phase. Der so zu erhaltende Aufbau wird anschließend in verschiedenen Verformungsschritten, die gegebenenfalls durch eine Wärmebehandlung bei erhöhter Temperatur unterbrochen sein können, auf eine gewünschte Dimension eines Leitervorproduktes mit einem Leiterkern aus dem Vormaterial gebracht. Dieses Leitervorprodukt kann im Hinblick auf die Herstellung als ein einzelnes Leiterelement angesehen werden.

Bündelt man dann in an sich bekannter Weise mehrere solcher im allgemeinen drahtförmigen Leiterelemente in einer normalleitenden Umhüllung und verformt den so gewonnenen Aufbau, so erhält man einen Rohleiter mit entsprechender Anzahl von Leiterkernen. Dieser Rohleiter wird weiteren Verformungsschritten unter Einschluß von Flachbearbeitungsschritten wie Walzen sowie mindestens einem Glühschritt unterzogen, um so einen bandförmigen Multifilamentsupraleiter zu erhalten. Für derartige Multifilamentsupraleiter werden bevorzugt Filamente aus der Hoch-T_{c}-Phase vom 2223-Typ vorgesehen (vgl. z.B. "*Applied Superconductivity", Vol. 2*, *No. 3*/*4, 1994, Seiten 155 bis 162* oder "*Applied Superconductivity", Vol. 3, Nos. 1 bis 3*, *1995, Seiten 1 bis 5*).

Zur Herstellung eines aus der eingangs genannten EP 0 509 436 A2 zu entnehmenden Multifilamentleiters wird in entsprechender Weise zunächst ein Leitervorprodukt mit rechteckigem Querschnitt erstellt, dessen Leiterkerne aus dem Vormaterial ein Aspektverhältnis (= Leiterkernbreite/maximale Leiterkerndicke) von etwa 2 aufweist. Mehrere solcher rechteckiger Leitervorprodukte werden dann in einer rechteckigen Umhüllung gebündelt, indem sie nebeneinander und übereinander angeordnet werden. Der so gewonnene Aufbau wird anschließend zu einem Leiterelement flachgearbeitet, in dem das Vormaterial in Form von mehreren Leiterkernen in etwa das genannte Aspektverhaltnis aufweisen. Gemäß einer entsprechenden Bündelungstechnik werden anschließend in eine weitere normalleitende Umhullung mehrere solcher Mehrkern-Leiterelemente eingebracht. Zur Ausbildung des Endproduktes eines bandformigen Multifilamentsupraleiters wird dann dieser Aufbau einer querschnittsvermindernden Behandlung sowie einer Gluhbehandlung unterzogen. Die einzelnen Leiterkerne werden dabei in die supraleitenden Leiteradern überführt, wobei davon auszugehen ist, daß das Aspektverhältnis etwa gleich bleibt.

Ein rechteckförmiger Hoch-T_{c}-Multifilamentsupraleiter ist auch der *EP 0 397 943* A1 zu entnehmen. Dieser Supraleiter ist aus mehreren zu einer einzigen Reihe gestapelten, von einer Umhüllung umschlossenen Einzelleitern aufgebaut. Bei den Einzelleitern handelt es sich um fertige Einkern-Supraleiter mit jeweils einem Leiterfilament aus Hoch-T_{c}-Supraleitermaterial. Die Leiterfilamente weisen dabei gemäß den Figuren ein Aspektverhältnis von bis zu etwa 20 auf.

Ein zusammengesetzter Hoch-T_{c}-Supraleiter, der ein Laminat aus supraleitenden Leiteradern mit noch größerem Aspektverhältnis innerhalb einer normalleitenden Umhüllung aufweist, geht aus der *EP 0 531 188 A1* hervor. Das Laminat ist dabei durch eine Stapelung von normalleitenden Trägerfolien, auf denen unter Anwendung einer Siebdrucktechnik das Hoch-T_{c-}Supraleitermaterial ausgebildet ist, erstellt.

Darüber hinaus ist aus der *EP 0 503 525 A1* die Herstellung eines bandförmigen Hoch-T_{z}-Multifilament-Supraleiters durch Bündelung mehrerer bandförmiger Leiterelemente innerhalb einer rechteckförmigen Umhüllung zu entnehmen. Die Leiterelemente weisen dabei jeweils einen Leiterkern aus einem Vormaterial des gewünschten Hoch-T_{z}-Supraleitermaterials mit einer Bi-2223-Phase auf, wobei ein Aspektverhältnis von etwa 2 der Leiterkerne vorgesehen ist. Die die Leiterelemente aufnehmende Umhüllung soll dabei aus einer NiCu-Legierung bestehen.

Es zeigt sich jedoch, daß die bekannten bandförmigen Multifilamentsupraleiter eine fur einen technischen Einsatz noch zu geringe kritische Stromdichte J_{c} aufweisen. Für einen derartigen Einsatz werden nämlich kritische Stromdichte J_{c} von mindestens 30 kA/cm², vorzugsweise mindestens 50 kA/cm² (im Nullfeld, bei 77 K) gefordert.

Aufgabe der vorliegenden Erfindung ist es deshalb, ein Verfahren zur Herstellung eines bandförmigen Multifilamentsupraleiters mit den eingangs genannten Merkmalen anzugeben, mit dem auf verhältnismäßig einfache Weise Multifilamentsupraleiter mit einer hohen kritischen Stromdichte J_{c} von mindestens 30 kA/cm² zu erhalten sind. Ferner soll ein entsprechend hergestellter Multifilamentsupraleiter angegeben werden.

Diese Aufgabe wird erfindungsgemäß dadurch gelöst, daß flache, in der normalleitenden Umhüllung anzuordnende Leiterelemente ausgebildet werden, deren jeweils mindestens ein Leiterkern ein Aspektverhältnis von über 5 aufweist, und daß dann die mit den Leiterelementen versehene Umhüllung derart verformt wird, daß das Aspektverhältnis in den erhaltenen Leiterfilamenten des Leiterendproduktes über 50 liegt.

Es wurde nämlich erkannt, daß insbesondere im Hinblick auf hohe kritische Stromdichten es besonders günstig ist, wenn man bereits Leiterelemente mit ein verhältnismäßig hohes Aspektverhaltnis aufweisenden Leiterkernen in eine weitgehend rechteckige normalleitende Umhüllung einbringt und dann diesen Aufbau so verformt, daß das Aspektverhältnis zumindest in den meisten der Leiterfilamente den geforderten Wert von uber 50 hat. Damit läßt sich gegenuber den allgemein angewandten Verfahren zur Herstellung von bandförmigen Supraleitern, bei denen zunächst Leiterelemente mit kreisförmigem Querschnitt in einer hohlzylindrischen Umhüllung angeordnet werden und dieser Aufbau dann erst mindestens einem Flachbearbeitungsschritt unterzogen wird (vgl. die genannten Literaturstellen aus "Applied Superconductivity"), das Aspektverhältnis des Leiterfilamente deutlich erzöhen. Die mit der Erfindung verbundenen Vorteile sind folglich darin zu sehen, daß mit dem Verfahren bandförmige Supraleiter hergestellt werden können, die die für einen technischen Einsatz geforderte hohe kritische Stromdichte ermöglichen.

Vorteilhaft weist ein nach dem erfindungsgemäßen Verfahren hergestellter bandförmiger Supraleiter als normalleitendes Material der Leiterelemente und/oder der sie aufnehmenden Umhüllung Silber oder ein Silber als Hauptbestandteil enthaltendes Material auf. Auf diese Weise ist die für die Ausbildung der supraleitenden Hoch-Tc-Phase erforderliche Sauerstoffzufuhr über das normalleitende Material zu gewährleisten.

Vorteilhafte Ausgestaltungen des erfindungsgemäßen Verfahrens und des mit diesem hergestellten Supraleiter gehen aus den jeweils abhängigen Ansprüchen hervor.

In der DE 196 21 070 A1 wird ein bandförmiger Multifilamentsupraleiter mit mehreren, in einer normalleitenden Matrix eingebetteten supraleitenden Leiterkernen beschrieben. Die Leiterkerne enthalten ein Hoch-Tc-Supraleitermaterial, z.B. Bi-Cuprat mit einer Hoch-Tc-Phase vom 2223-Typ, und die normalleitende Matrix besteht aus Silber oder einem Material, das Silber als Hauptbestandteil enthält.

Nach entsprechenden Verformungs- und Wärmebehandlungsschritten weist der HTS-Multifilamentsupraleiter Leiterkerne mit einem Aspektverhältnis zwischen 20 und 80 auf und kann kritische Stromdichten von über 50 kA/cm² erreichen.

Der Vorteil des erfindungsgemäßen Verfahrens gegenüber der DE 196 21 070 A1 ist darin zu sehen, dass auf einfache Weise noch höhere Aspektverhältnisse von über 80 erreicht werden. Gemäß der DE 196 21 070 A1 ist offensichtlich eine stufenweise Abnahme der Härte des Matrixmaterials vom Leiterzentrum nach außen erforderlich (Anspruch 2), um die gewünschten Eigenschaften im Endprodukt zu realisieren, was die Produktion entsprechend kompliziert und das Verfahren selber natürlich einschränkt. Gemäß der vorliegenden Erfindung gelingt es dagegen, durch einfach zu verwirklichende geometrische Voraussetzungen noch bessere Ergebnisse zu erzielen, ohne bei der Verwendung des Matrixmaterials zusätzlichen Einschränkungen unterworfen zu sein.

Die Erfindung wird nachfolgend unter Bezugnahme auf die Zeichnung anhand eines bevorzugten Ausführungsbeispieles noch weiter erläutert. Dabei zeigen jeweils schematisch als Querschnitt
- Figur 1: einen mit Leiterelementen verfüllten Leiteraufbau während des erfindungsgemäßen Verfahrens und
- Figur 2: ein mit dem Verfahren erhaltenes Leiterendprodukt als bandförmiger Multifilamentsupraleiter.
In den Figuren ist die gewählte Darstellung aus Gründen einer besseren Übersichtlichkeit nicht maßstabgetreu.

Ein erfindungsgemäß hergestellter Supraleiter stellt einen langgestreckten Verbundkörper in Bandform dar, der ein in wenigstens ein normalleitendes Matrixmaterial eingebettetes Hoch-Tc-Supraleitermaterial (HTS-Material) zumindest weitgehend phasenrein enthält. Als HTS-Material soll ein Bi-Cuprat vorgesehen sein, das einen hohen Anteil von insbesondere über 80 % an der sogenannten 2223-Phase enthält. Ein entsprechendes HTS-Material ist dem Grundtyp (Bi, Pb)₂Sr₂Ca₂Cu₃O₁₀₊ₓ zuzuordnen, wobei gegebenenfalls auf die Pb-Substitution verzichtet werden kann. Die übrigen Komponenten des HTS-Materials können in bekannter Weise teilweise durch andere metallische Elemente substituiert sein. Zur Herstellung eines entsprechenden HTS-Leiters kann vorteilhaft die bekannten Pulver-im-Rohr-Technik zugrundegelegt werden (vgl. z.B. die *DE 44 44 937 A1*). Hierzu wird ein Vormaterial insbesondere in Form von Ausgangspulvern, die eine Ausbildung der gewünschten supraleitenden Phase ermöglichen, in ein Hüllrohr eingebracht, das als das normalleitende Matrixmaterial für das fertige Endprodukt des Supraleiters dient. Gegebenenfalls kann auch das bereits fertige Hoch-T_{c}-Supraleitermaterial zur Füllung vorgesehen werden. Das Hüllrohrmaterial ist unter dem Gesichtspunkt auszuwählen, daß es bei der Leiterherszellung keine unerwünschten Reaktionen mit den Komponenten des HTS-Materials sowie mit Sauerstoff eingeht sowie einen Sauerstofftransport aufgrund guter Diffusionseigenschaft ermöglicht. Deshalb ist als Hüllrohrmaterial besonders ein Ag-Material geeignet, das entweder reines Ag beispielsweise in Form von kaltverfestigtem Silber oder rekristallisiertem Silber oder in Form einer Legierung mit Ag als Hauptbestandteil (d.h. zu mehr als 50 Gew.-%)enthält. Auch kann pulvermetallurgisch hergestelltes Silber vorgesehen werden. Daneben ist auch dispersionsgehartetes Silber geeignet.

Der Aufbau aus dem mit dem Vormaterial gefüllten Hüllrohr wird dann mindestens einer Verformungsbehandlung unterzogen, für die alle bekannten Verfahren wie z.B. Strangpressen, Hämmern oder Ziehen in Frage kommen. Diese Verfahren konnen auch miteinander kombiniert werden. Diese mechanischen Behandlungen können sowohl bei Raumtemperatur als auch bei dem gegenüber erhöhter oder tieferer Temperatur durchgeführt werden. Nach der Verformungsbehandlung liegt dann ein Einkernleiter in Form eines Verbundkörpers vor, der im allgemeinen eine Drahtform mit einem kreisförmigen Durchmesser von insbesondere 1 bis 20 mm hat. Dieser Einkernleiter wird dann in wenigen, beispielsweise 1 bis 5 Verfahrensschritten zu einem Leiterelement flachgearbeitet, insbesondere gewalzt. Seine maximale Dicke liegt dann im allgemeinen zwischen 0,1 und 1 mm bei einem Aspektverhältnis, das vorteilhaft bei über 5, insbesondere über 10 und vorzugsweise über 20 liegen soll.

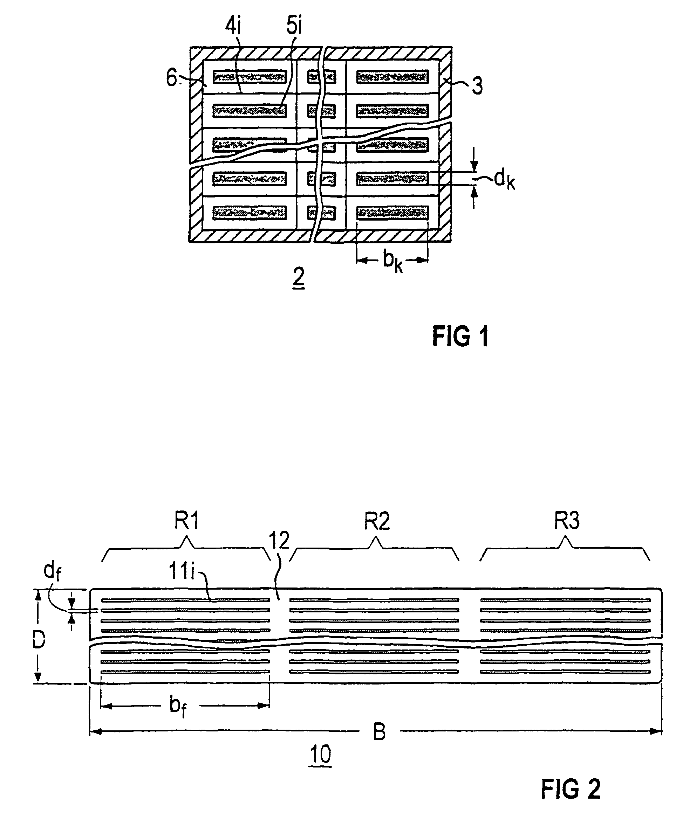

Gemäß Figur 1 wird anschließend ein Aufbau 2 aus einer Umhüllung 3 und einer von dieser umschlossenen Vielzahl derartiger bandförmiger Leiterelemente 4i mit Leiterkernen 5i aus dem Vorprodukt des Supraleitermaterials oder gegebenenfalls aus dem bereits zumindest teilweise ausgebildeten Supraleitermaterial erstellt. In dem Innenraum 6 der Umhullung mit zumindest weitgehend rechteckigem Querschnitt sind dabei die einzelnen Leiterelemente 4i übereinander und in mehreren Reihen nebeneinander angeordnet. Die Leiterkerne 5i der Leiterelemente 4i besitzen jeweils das geforderte große Verhältnis von Leiterkernbreite bₖ zu Leiterkerndicke dₖ. Die Umhüllung 3 besteht dabei aus einem normalleitenden Material wie z.B. aus dem Matrixmaterial der Leiterelemente oder auch aus einem davon verschiedenen Material. Ein entsprechender Aufbau kann auch so erstellt werden, daß man zunächst einen Stapel aus den Leiterelementen bildet und dann diesen Stapel mit einer Umhullung versieht.

Der so verfüllte Aufbau 2 bzw. Rechteckleiter wird anschlie-βend einer weiteren Verformungsbehandlung unterzogen, die gegebenenfalls von Wärmebehandlungsschritten unterbrochen oder mit solchen Schritten kombiniert sein kann. Bevorzugt wird ein Ziehen in mindestens einem Ziehschritt unter Verwendung eines Ziehsteins mit rechteckiger Ziehöffnung vorgesehen. Man erhält so einen kompaktierten, rechteckformigen Rohleiter, dessen Breite z.B. zwischen 1 und 5 mm liegt bei einer Dicke zwischen 0,3 und 1,5 mm. Als letzter Schritt einer Rohleiterumformung erfolgt ein Walzen in wenigen Schritten auf 0,15 bis 0,4 mm Dicke. Daran schließt sich eine thermomechanische Behandlung in bekannter Weise an.

Figur 2 zeigt einen Querschnitt durch das entsprechend hergestellte Endprodukt eines bandförmigen Multifilamentsupraleiters 10 mit einer Bandbreite B von etwa 3 mm und einer Banddicke D von etwa 0,25 mm. Seine zu bandförmigen Leiterfilamenten 11i verformten Leiterkerne aus Bi-Cuprat mit der supraleitenden Hoch-T_{c}-Phase vom 2223-Typ sind in mehreren nebeneinanderliegenden Reihen R1 bis R3 jeweils übereinander gestapelt und in einer Matrix 12 aus reinem Ag oder einem mindestens zu 50 % Ag enthaltenden Material eingebettet. Jedes Filament hat eine Filamentbreite bₜ von etwa 1 mm und eine maximale Filamentdicke d_{f} von höchstens etwa 10 µm. Es ergibt sich so ein vorteilhaftes Aspektverhältnis von etwa 100.

Gemäß einem konkreten Ausführungsbeispiel wurden folgende Parameter für ein erfindungsgemäßes Verfahren vorgesehen:
- Hämmern und Ziehen eines Einkernleiters bis 1,9 mm Durchmesser,
- Walzen des Einkernleiters in drei Schritten auf 0,38 mm Dicke zur Ausbildung eines bandförmigen Leiterelementes mit dem geforderten hohen Aspektverhältnis seines Leiterkerns,
- Bündelung von 45 Leiterelementen in drei nebeneinanderliegenden Reihen à 15 Elementen,
- Ziehen des so verfüllten Rechteckleiters mit einer Ag-Umhüllung (16 x 8 mm Außenabmessung, 14 x 6 mm Innenabmessung) auf 2 x 1 mm Außenabmessung,
- Walzen des so erhaltenen Rohleiters auf 0,3 mm Dicke in einem Walzschritt
- thermomechanische Behandlung.
Im Vergleich zu einem standardmäßig umgeformten Multifilamentleiter unter Verwendung von 55 runden Einkernleiterelementen (vgl. "*IEEE Transactions on Applied Superconductivity*", *Vol. 7*, *No*. *2*, *Juni 1997, Seiten 355 bis 358*) wurde eine Steigerung der kritischen Stromdichte um etwa 50 % erreicht.

Gemäß dem dargestellten Ausführungsbeispiel wurde davon ausgegangen, daß Leiterelemente 4i in Form von Einkernleitern vorgesehen werden. Will man jedoch Multifilamentsupraleiter mit sehr hoher Anzahl von Leiterfilamenten ausbilden, so ist es selbstverständlich auch moglich, in bekannter Weise durch eine Bündelungstechnik aus bandförmigen bzw. rechteckigen Einkernleitern Leiterelemente mit mehreren Leiterkernen auszubilden und diese Mehrkern-Leiterkerne dann in der angegebenen Weise zu dem gewünschten Leiterendprodukt des Multifilamentleiters weiterzuverarbeiten (vgl. die genannte EP 0 509 436 A2).

## Patentansprüche

1. Verfahren zur Herstellung eines bandförmigen Multifilamentsupraleiters mit mehreren supraleitenden Leiterfilamenten, welche jeweils ein metalloxidisches Supraleitermaterial enthalten, das zumindest teilweise ein Bi-Cuprat mit einer Hoch-T_{c}-Phase vom 2223-Typ aufweist und von mindestens einem normalleitenden Matrixmaterial umgeben ist, bei welchem Verfahren flachgearbeitete Leiterelemente ausgebildet werden, die ein von normalleitendem Material umgebenes Vormaterial des Supraleitermaterials oder das Supraleitermaterial in Form von mindestens einem Leiterkern mit einem Aspektverhältnis größer 1 besitzen, wobei das Aspektverhältnis der Quotient von Leiterkernbreite zu maximaler Leiterkerndicke ist, mehrere solche Leiterelemente innerhalb einer zumindest weitgehend rechteckigen Umhüllung aus normalleitendem Material übereinander und/oder nebeneinander angeordnet werden und dieser Aufbau mittels einer querschnittsvermindernden Behandlung sowie einer Glühbehandlung in das bandförmige Endprodukt des Multifilamentsupraleiters mit zu den Leiterfilamenten verformten Leiterkernen überführt wird, **dadurch gekennzeichnet, daß** flache, in der normalleitenden Umhüllung (3) anzuordnende Leiterelemente (4i) ausgebildet werden, deren jeweils mindestens ein Leiterkern (5i) ein Aspektverhältnis (bₖ/dₖ) von über 5 aufweist, und daß dann die mit den Leiterelementen versehene Umhüllung derart verformt wird, daß das Aspektverhältnis (b_{f}/d_{f}) in den erhaltenen Leiterfilamenten (11i) des Leiterendproduktes über 50 liegt.

2. Verfahren nach Anspruch 1, **dadurch gekennzeichnet, daß** die Leiterkerne (5i) derart verformt werden, daß die Leiterfilamente (11i) ein Aspektverhältnis (b_{f}/d_{f}) von über 80 aufweisen.

3. Verfahren nach Anspruch 1 oder 2, **dadurch gekennzeichnet, daß** Leiterkerne (5i) mit einem Aspektverhältnis (bₖ/dₖ) von über 10, vorzugsweise über 20 ausgebildet werden.

4. Verfahren nach einem der Anspruche 1 bis 3, **dadurch gekennzeichnet, daß** zur Ausbildung der Leiterelemente (4i) zunächst ein den Leiterkern (5i) enthaltendes Leitervorprodukt mit einem kreisförmigen Durchmesser zwischen 1 und 20 mm hergestellt wird, das anschließend auf eine Dicke zwischen 0,1 und 1 mm flachgearbeitet wird.

5. Verfahren nach einem der Ansprüche 1 bis 4, **dadurch gekennzeichnet, daß** die mit den Leiterelementen (4i) versehene Umhüllung (3) mindestens einen Ziehschritt unter Verwendung eines Ziehsteins mit rechteckiger Öffnung unterzogen wird.

6. Bandförmiger Multifilamentsupraleiter, hergestellt nach einem Verfahren gemäß einem der Ansprüche 1 bis 5, **dadurch gekennzeichnet, dass** die Leiterfilamente (11i) ein Aspektverhältnis (b_{f}/d_{f}) von über 80 aufweisen.

7. Bandförmiger Multifilamentsupraleiter nach Anspruch 6, **dadurch gekennzeichnet, dass** das normalleitende Material der Leiterelemente (4i) und der sie aufnehmenden Umhüllung (3) Silber und/oder ein Silber als Hauptanteil enthaltendes Material ist.

8. Supraleiter nach Anspruch 6 oder 7, **dadurch gekennzeichnet, dass** das normalleitende Material der Umhüllung (3) das normalleitende Material der Leiterelemente (4i) ist.

9. Supraleiter nach einem der Ansprüche 6 bis 8, **dadurch gekennzeichnet, dass** die Leiterfilamente (11i) eine Filamentdicke (d_{f}) von höchstens 10 *µ*m aufweisen.

10. Supraleiter nach einem der Ansprüche 6 bis 9, **gekennzeichnet durch** eine kritische Stromdichte von mindestens 30 kA/cm² bei 77 K und fehlendem äußeren Magnetfeld.

## Claims

1. Method of producing a strip-shaped multifilament superconductor comprising a plurality of superconducting conductor filaments each containing a metal oxide superconductor material at least partially comprising a bismuth cuprate with a high T_{c} phase of the 2223 type and surrounded by at least one normal-conducting matrix material, in which method flattened conductor elements having a precursor of the superconductor material surrounded by a normal-conducting material or having the superconductor material in the form of at least one conductor core having an aspect ratio of more than 1 are formed, the aspect ratio being the quotient of the conductor core width and the maximum conductor core thickness, a plurality of conductor elements of this kind are arranged one on top of the other and/or one alongside the other within an at least substantially rectangular sheath of normal-conducting material and this structure is converted into the strip-shaped end product of the multifilament superconductor comprising conductor cores formed into the conductor filaments by means of section-reducing treatment and annealing treatment, **characterised in that** flat conductor elements (4i) to be arranged in the normal-conducting sheath(3) and at least one conductor core (5i) of each of which has an aspect ratio (bₖ/dₖ) of more than 5 are formed and that the sheath provided with the conductor elements is then formed in such a manner that the aspect ratio (b_{f}/d_{f}) in the resulting conductor filaments (11i) of the final conductor is more than 50.

2. Method according to claim 1, **characterised in that** the conductor cores (5i) are formed in such a manner that the conductor filaments (11i) have an aspect ratio (b_{f}/d_{f}) of more than 80.

3. Method according to claim 1 or claim 2, **characterised in that** conductor cores (5i) having an aspect ratio (bₖ/dₖ) of more than 10, preferably more than 20, are formed.

4. Method according to one of claims 1 to 3, **characterised in that** a conductor precursor containing the conductor core (5i) and having a circular diameter of between 1 and 20 mm is first produced and is then flattened to a thickness of between 0.1 and 1 mm in order to form the conductor elements (4i).

5. Method according to one of claims 1 to 4, **characterised in that** the sheath (3) provided with the conductor elements (4i) is subjected to at least one drawing step using a die with a rectangular opening.

6. Strip-shaped multifilament superconductor produced by a method according to one of claims 1 to 5, **characterised in that** the conductor filaments (11i) have an aspect ratio (b_{f}/d_{f}) of more than 80.

7. Strip-shaped multifilament superconductor according to claim 6, **characterised in that** the normal-conducting material of the conductor elements (4i) and of the sheath (3) receiving them is silver and/or a material containing silver as the main constituent.

8. Superconductor according to claim 6 or claim 7, **characterised in that** the normal-conducting material of the sheath (3) is the normal-conducting material of the conductor elements (4i).

9. Superconductor according to one of claims 6 to 8, **characterised in that** the conductor filaments (11i) have a filament thickness (d_{f}) of no more than 10 µm.

10. Superconductor according to one of claims 6 to 9, **characterised by** a critical current density of at least 30 kA/cm² at 77 K and with no external magnetic field.

## Revendications

1. Procédé de fabrication d'un supraconducteur à multifilaments en forme de ruban avec plusieurs filaments supraconducteurs qui contenant chacun un matériau supraconducteur en oxyde métallique, qui présente au moins partiellement un bi-cuprate avec une phase T_{c} haute du type 2223 et entouré par au moins un matériau de matrice conducteur normalement, selon lequel on réalise des éléments conducteurs plats qui présentent un pré-matériau du matériau du supraconducteur entouré par un matériau normalement conducteur ou le matériau du supraconducteur en forme d'au moins un noyau conducteur avec un rapport d'aspect supérieur à 1, le rapport d'aspect étant le quotient entre la largeur du noyau conducteur et l'épaisseur du noyau conducteur, plusieurs de tels éléments conducteurs sont superposés et/ou juxtaposés dans une enveloppe au moins essentiellement rectangulaire en matériau normalement conducteur, et
cette structure est transformée au moyen d'un traitement réducteur de la section transversale ainsi que d'un traitement de recuit pour obtenir le produit final en forme de ruban du supraconducteur à multifilaments avec des noyaux conducteurs déformés en filaments conducteurs,
**caractérisé en ce qu'**
on réalise des éléments conducteurs (4i) plats à disposer dans une enveloppe (3) normalement conductrice dont respectivement l'au moins un noyau conducteur (5i) présente un rapport d'aspect (b_{K/}d_{K}) supérieur à 5, et
on déforme ensuite l'enveloppe munie des éléments conducteurs de telle sorte que le rapport d'aspect (b_{F}/d_{F}) dans les filaments conducteurs (11i) obtenus du produit conducteur final se situe au-dessus de 50.

2. Procédé selon la revendication 1,
**caractérisé en ce que**
les noyaux conducteurs (5i) sont déformés de telle sorte que les filaments conducteurs (11i) présentent un rapport d'aspect (b_{F}/d_{F}) supérieur à 80.

3. Procédé selon la revendication 1 ou 2,
**caractérisé en ce que**
les noyaux conducteurs (5i) sont réalisés avec un rapport d'aspéct (b_{K}/d_{K}) supérieur à 10, de préférence supérieur à 20.

4. Procédé selon l'une quelconque des revendications 1 à 3,
**caractérisé en ce que**
pour réaliser les éléments conducteurs (4i) on fabrique d'abord un pré-produit conducteur d'un diamètre circulaire entre 1 et 20 mm contenant le noyau conducteur (5i), qui est ensuite aplati sur une épaisseur entre 0,1 et 1 mm.

5. Procédé selon l'une quelconque des revendications 1 à 4,
**caractérisé en ce que**
l'enveloppe (3) munie des éléments conducteurs (4i) est soumise à au moins une étape d'étirage en utilisant une filière de filage avec une ouverture rectangulaire.

6. Supraconducteur à multifilaments en forme de ruban, fabriqué suivant un procédé selon l'une quelconque des revendications 1 à 5,
**caractérisé en ce que**
les filaments conducteurs (11i) présentent un rapport d'aspect (b_{f}/d_{f}) supérieur à 80.

7. Supraconducteur à multifilaments en forme de ruban selon la revendication 6,
**caractérisé en ce que**
le matériau normalement conducteur des éléments conducteurs (4i) et de l'enveloppe (3) les recevant est l'argent et/ou un matériau contenant principalement de l'argent.

8. Supraconducteur selon la revendication 6 ou 7,
**caractérisé en ce que**
le matériau normalement conducteur de l'enveloppe (3) est le matériau normalement conducteur des éléments conducteurs (4i).

9. Supraconducteur selon l'une quelconque des revendications 6 à 8,
**caractérisé en ce que**
les filaments conducteurs (11i) présentent une épaisseur de filament (d_{f}) de 10 µm au maximum.

10. Supraconducteur selon l'une quelconque des revendications 6 à 9,
**caractérisé par**
une densité de courant critique d'au moins 30 kA/cm² à 77 K et en l'absence d'un champ magnétique extérieur.
